Europäisches Patentamt

European Patent Office

Office européen des brevets

(19)

(11) **EP 0 762 488 B1**

(12) **EUROPEAN PATENT SPECIFICATION**

(45) Date of publication and mention
of the grant of the patent:
**07.04.2004 Bulletin 2004/15**

(51) Int Cl.⁷: **H01L 21/3213**

(21) Application number: **96305578.5**

(22) Date of filing: **30.07.1996**

(54) **Cleaning solution for cleaning semiconductor device and cleaning method using the same**

Reinigungslösung für Halbleiteranordnung und Reinigungsmethode

Procédé et solution pour le nettoyage de composant semi-conducteur

(84) Designated Contracting States:
**DE GB NL**

(30) Priority: **18.08.1995 KR 9525459**

(43) Date of publication of application:
**12.03.1997 Bulletin 1997/11**

(73) Proprietor: **SAMSUNG ELECTRONICS CO., LTD.**
**Suwon-city, Kyungki-do 441-373 (KR)**

(72) Inventor: **Nam, Jae-woo**
**Suwon-city, Kyungki-do (KR)**

(74) Representative: **Hall, Marina**
**Elkington and Fife**
**Prospect House,**
**8 Pembroke Road**
**Sevenoaks, Kent TN13 1XR (GB)**

(56) References cited:
EP-A- 0 662 705          US-A- 4 215 005
US-A- 4 343 677

- **PATENT ABSTRACTS OF JAPAN vol. 15, no. 428 (E-1128), 30 October 1991 & JP 03 179737 A (HASHIMOTO KASEI KOGYO), 5 August 1991,**
- **PATENT ABSTRACTS OF JAPAN vol. 17, no. 415 (E-1407), 3 August 1993 & JP 05 082503 A (HASHIMOTO KASEI), 2 April 1993,**

## Description

Background of the Invention

The present invention relates to a cleaning solution for cleaning a semiconductor device, and more particularly, to a cleaning solution for cleaning metal layers of a semiconductor device and a cleaning method using the same.

During the manufacture a semiconductor device, as the semiconductor device becomes highly integrated, it is very important to remove defects in its circuit wiring. Therefore, a cleaning process is repeatedly performed on the device, typically several tens of times throughout its manufacture. The cleaning process removes dust, particles, organic material, inorganic material and various heavy metal ions. That is to say, the cleaning process is performed for the purpose of removing undesirable foreign materials in a semiconductor device circuit, and an etching process is broadly included in the cleaning process.

In cleaning a semiconductor substrate having metal layers, e.g., aluminum layers, formed thereon, a cleaning solution comprised of an amine such as aminoethyl piperidine, isopropyl amine, hydroxyethyl morpholine, amino alcohol, diethylenetriamine, and a solvent such as N-methyl-2-pyrrolidone (NMP), dimethyl sulfoxide (DMSO), dimethylacetamide (DMAC), AMF, sulfotane, BLO, or a mixture thereof, may be used for stripping polymers generated in forming contact holes in photoresists formed on the metal layers and intermetal dielectric films formed between the metal layers.

However, in such cases, a substantial amount of the metal layers is chemically corroded, which reduces or prevents the maintenance of the resistance and conductivity which the semi-conductor device is designed for. In order to minimize the corrosion of the metal layers and to easily strip the polymers generated during a dry-etching process, another type of cleaning solution, e.g., NP-935 containing DMAC and diethanolamine, may be used in the cleaning process. However, such a solution has a poor capability for removing particles. Thus, after such a cleaning process, it is necessary to perform a further cleaning process using a cleaning solution dedicated to the removal of the particles called SC-1 which is composed of ammonia ($NH_4OH$), hydrogen peroxide ($H_2O_2$) and deionized water ($DI-H_2O$).

Other solutions are known to remove etching residues on metal layers. EP-A-0 662 705 for example discloses the use of a solution of fraternary ammonium salt in admixture with a fluoride.

Summary of the Invention

To solve the above-described problems, it is, therefore, an object of the present invention to provide a cleaning solution suitable for use on a semiconductor device which can remove polymers and particles contaminating the metal layers of the semiconductor in a single cleaning process but without eroding metal layers.

It is a further object of the present invention to . provide a cleaning method for cleaning a semiconductor device using the cleaning solution of the invention.

The invention provides a cleaning solution suitable for use in cleaning metal layers of a semiconductor device, in which the solution consists of aqueous ammonia ($NH_4OH$), methanol ($CH_3OH$), hydrofluoric acid (HF) and deionized water ($H_2O$) having a pH of 9-11 the mixture ratio of $NH_4OH$, $CH_3OH$ and $H_2O$ in the cleaning solution being 1:10:1 by volume, the ratio of HF to the mixture solution of $NH_4OH$, $CH_3OH$ and $H_2O$ being 2000~10,000ppm to 1 the solution being formed from $NH_4OH$ at a concentration of 1-50%, methanol at a concentration of 90-100% and HF at a concentration of 1-60%.

The present invention further provides a method for cleaning metal layers on a semiconductor substrate, the method comprising the step of cleaning the semiconductor substrate having the metal layers formed thereon using a cleaning solution composed of aqueous ammonia ($NH_4OH$), methanol ($CH_3OH$), hydrofluoric acid (HF) and deionized water ($H_2O$) as described above.

It is preferred that the temperature of the cleaning solution is 20~100°C, more preferably 45°C. It is preferred that the duration of cleaning during the cleaning step is 8 hours or less, more preferably 10 minutes or less. According to an embodiment of the invention, the metal layers are made of double layers of titanium or titanium nitride, and aluminum alloy.

Brief Description of the Drawings

The above objects and advantages of the present invention will become more apparent by describing in detail a preferred embodiment thereof with reference to the attached drawings in which:

FIG. 1 is a graph showing the corrosion of metal layers depending on the composition of a cleaning solution according to the present invention;

FIG. 2 illustrates pictures comparing the particle stripping capabilities of cleaning solutions conventionally used in the art and cleaning solutions of the present invention;

FIGS. 3 and 4 are scanning electron microscopy (SEM) pictures comparing the polymer stripping capabilities of cleaning solutions conventionally used in the prior art and cleaning solutions according to the present invention;

FIG. 5 is a graph showing the concentration of hydrogen ions in a cleaning solution according to the present invention;

FIG. 6 is a graph showing the change in the concentration of hydrogen ions in the cleaning solution according to the . present invention, over time; and

FIG. 7 is a graph showing the pit corrosion density of metal layers using a cleaning solution according to the present invention, over time.

Detailed Description of the Invention

The cleaning solution according to the present invention consists of aqueous ammonia ($NH_4OH$), methanol ($CH_3OH$), hydrofluoric acid (HF) and deionized water ($H_2O$).

The aqueous ammonia has 1~50% purity, the methanol has 90~100% purity and the hydrofluoric acid has 1~60% purity. The mixture ratio of the cleaning solution by volume, of $NH_4OH:CH_3OH:H_2O$ is 1:10:1. The volume of HF is 2000~10,000ppm with respect to the mixture solution of $NH_4OH$, $CH_3OH$ and $H_2O$.

The following examples describe cleaning of a semiconductor substrate having metal layers formed thereon using the cleaning solution according to the present invention, demonstrating the corrosion properties after cleaning and the polymer and particle stripping capabilities of the cleaning solution.

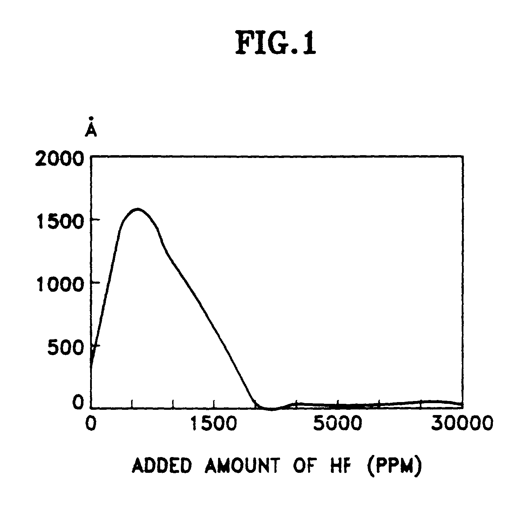

FIG. 1 is a graph showing the corrosion of metal layers in a semiconductor device depending on the composition of a cleaning solution according to the present invention.

In detail, FIG. 1 shows corrosion values depending on the added amount of HF, when the semiconductor substrate having metal layers formed thereon is cleaned with a cleaning solution made of a mixture of $NH_4OH$, $CH_3OH$ and $H_2O$ in a volume ratio of 1:10:1 and in which 500~30,000ppm of HF is added thereto. Here, the X axis represents the added amount of HF and the Y axis represents the corrosion of metal layers. The corrosion of metal layers in the semiconductor device increases until the amount of HF added is 600~700ppm, but then gradually decreases thereafter when the amount of HF added increases over 700ppm. If the added amount of HF exceeds about 2,000ppm, the corrosion of metal layers becomes almost zero. Such reactions can be explained in the following relationship.

$$NH_4OH \rightarrow NH_4^+ + OH^- \qquad ①$$

$$HF \rightarrow H^+ + F^- \qquad ②$$

$$F^-(aq.) + H_2O \Leftrightarrow NH_4^+ + OH^- + HF \text{ (under } NH_3 \text{ atmosphere)} \qquad ③$$

In ① and ②,

$$\Rightarrow NH_4^+ + F^- + H^+ + OH^-$$

$$\Rightarrow NH_4F + H_2O$$

In relationship ③, fluoride ions ($F^-$) react with water ($H_2O$) to induce hydroxyl ions ($OH^-$), but the reaction direction will change depending on the amount of hydrofluoric acid (HF) under an $NH_3$ atmosphere. Particularly, under the $NH_3$ atmosphere, if the amount of HF is trivial (600~700ppm or less), the reaction proceeds forwardly from left to right to produce hydroxyl ions. However, if the amount of HF is increased to between 600~700ppm or more, then the reaction proceeds backwardly from right to left to reduce the amount of hydroxyl ions (an $OH^-$ annihilation reaction). Therefore, as the amount of HF is increased, the presence of hydroxyl ions is decreased, thereby resulting in a reduction in the corrosion of metal layers.

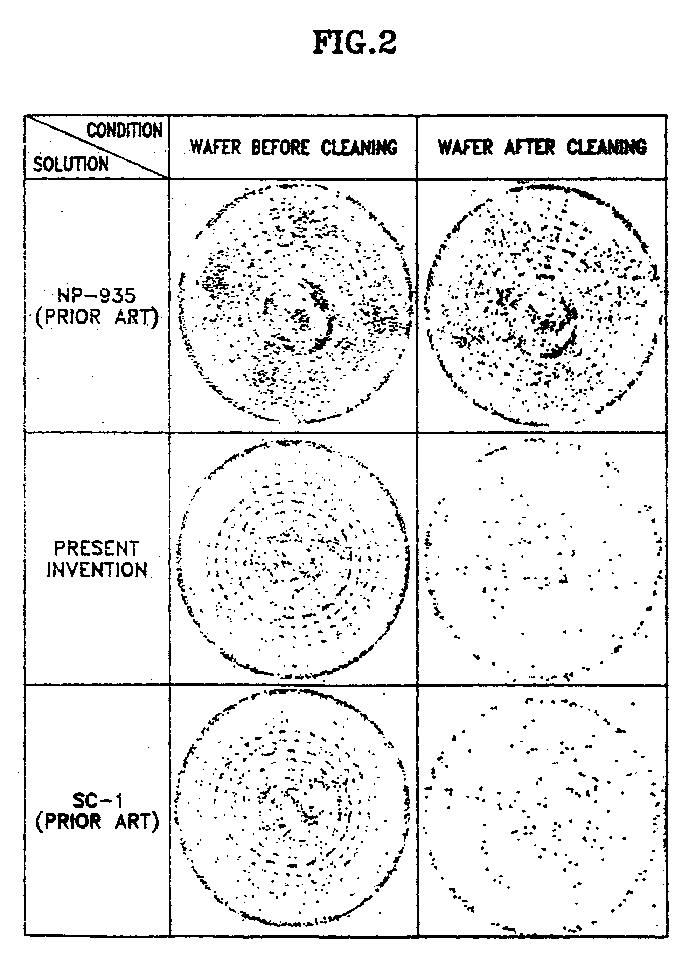

FIG. 2 illustrates pictures comparing the particle stripping capabilities of cleaning solutions according to the prior art and according to the present invention.

Specifically, the particle stripping capabilities of a cleaning solution according to the invention was compared with the effect of conventional cleaning solutions, NP-935 and SC-1. The particle stripping capability of the conventional cleaning solution NP-935 was only about 10%, whereas, the particle stripping capability of the cleaning solution according to the present invention was 80%. When compared to SC-1 which has the best stripping capability among the conventional cleaning solutions, the particle stripping capability of the cleaning solution according to the present invention is shown to be similar to that of SC-1.

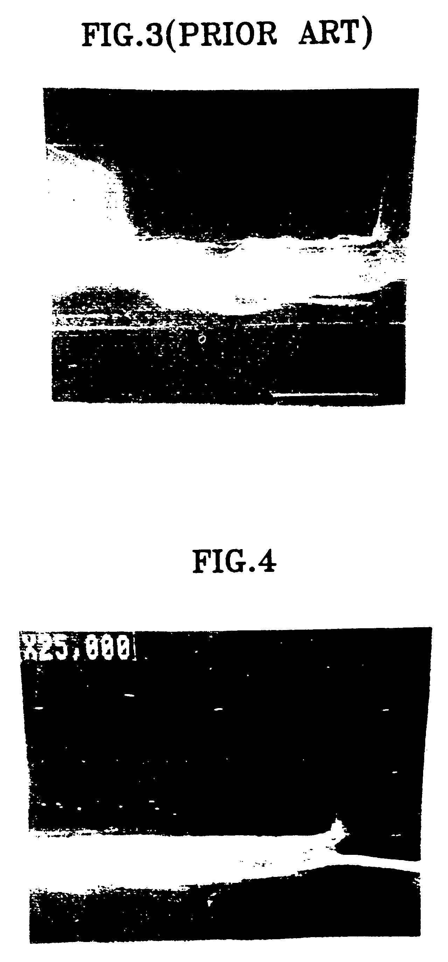

FIGS. 3 and 4 are scanning electron microscopy (SEM) pictures comparing the polymer stripping capabilities of cleaning solutions according to the conventional art and cleaning solutions according to the present invention, respectively.

In detail, unwanted polymers are generated during the etching of metal layers by a dry etching process. If the polymers are not removed even after removal of a photoresist, then they will exert an adverse influence on the deposition process of the metal layers which process follows the etching, that is, the contact resistance is increased. Therefore, it is highly desirable to remove the polymers. If the substrate having metal layers formed thereon is cleaned with the cleaning solution according to the present invention, the polymer stripping capability of the cleaning solution according to the present invention is not lower than that of the conventional cleaning solution NP-295 (FIG. 3), but in fact exhibits a higher capability, as shown in FIG. 4. The NP-935 cleaning solution is generally processed at a temperature of 70°C for more than 30 minutes and the cleaning solution should be rinsed for about three minutes using isopropyl alcohol and deionized water. Hence, a long processing time is required when using NP-935 as the cleaning solution which is very undesirable.

In comparison, since the cleaning method according to the present invention requires only one to ten minutes for the rinsing process and ten minutes for the rotational dry process at a temperature of 20°C ~ 100°C, preferably 45°C, the cleaning processing time can be shortened by more than ten minutes.

The hydrogen ion concentration of the cleaning solution with regard to the stripping of particles and to pit corrosion density over time, will now be described.

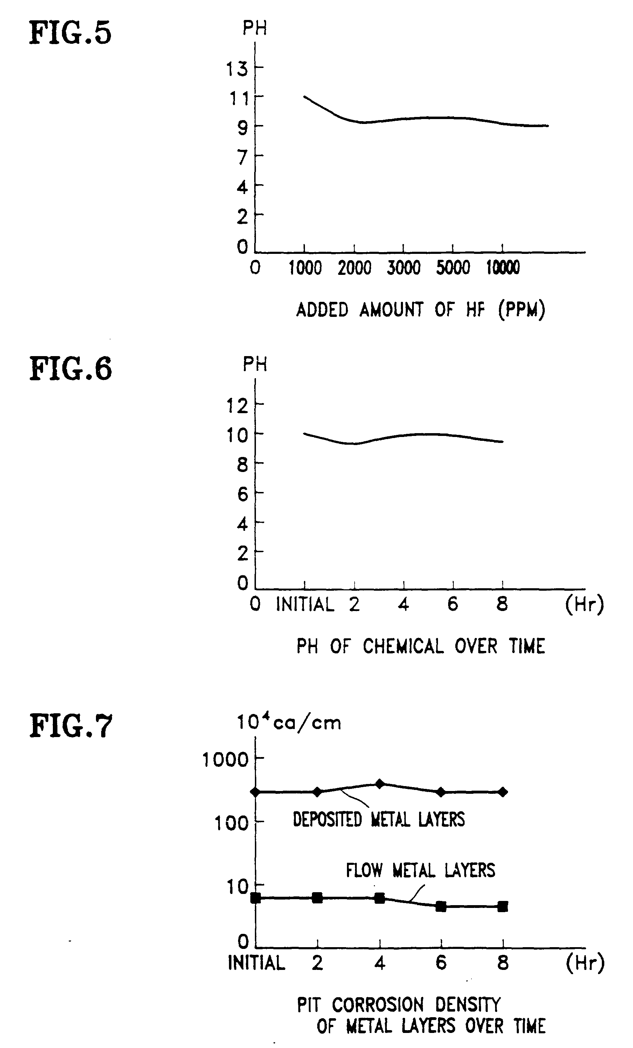

FIG. 5 is a graph showing the hydrogen ion concentration (pH) of a cleaning solution according to the present invention.

Specifically, when the volume ratio of $NH_4OH$ to $CH_3OH$ to $H_2O$ is 1:10:1, the hydrogen ion concentration (pH) depending on the added amount of HF is shown in FIG. 5. Before adding HF, the pH was about 11. However, as HF was added, the pH gradually decreases to about 9, when the amount of HF added is about 10,000ppm. The most suitable pH for stripping particles is 9-10. Therefore, the pH of the cleaning solution according to the present invention is suitable for this purpose.

FIG. 6 is a graph showing the change in the concentration of hydrogen ions in the cleaning solution according to the present invention, over time.

Specifically, the change of pH was tested over time starting from the manufacture of a cleaning solution according to the present invention. Referring to FIG. 6, it can be seen that there is no large change in pH, even after eight hours after the cleaning solution had been manufactured. Specifically, an initial pH of 9.6 only changed to 9.2 after eight hours. The cleaning solution of the present invention, therefore, performs its function fully within eight hours. After eight hours the composition of the solution has evaporated considerably. Therefore, it is preferable to additionally add respective compositions comprising the cleaning solution according to the invention.

FIG. 7 is a graph showing the pit corrosion density in the metal layers overtime after using the cleaning solution according to the present invention.

Specifically, samples having metal layers are dipped in a cleaning solution according to the present invention and the pit corrosion density thereof was observed for eight hours. The pit corrosion is a corrosion phenomenon in which specific parts are locally taken away at the particle boundary of metal. It can be seen that there is little change in the pit density over eight hours, which is the available effective time of the cleaning solution. The samples used in the present invention was deposited metal layers and flow metal layers. The two types of metal layers do not differ in their characteristics, but the size of the particle boundary in flow metal layers is about ten times greater than the size of the particle boundary in deposited metal layers.

The cleaning solution according to the present invention, therefore, has the polymer stripping capability equivalent to that of the conventionally used NP-935 and has the particle stripping capability equivalent to that of the conventionally used SC-1. Therefore, the requirement for two processes using the two cleaning solutions, both procedures being performed separately, is removed and simplified into a single cleaning process. The cleaning solution according to the present invention can be manufactured by simply mixing the respective compositions. In addition, the cleaning solution according to the present invention can strip polymers and particles within a short time, without etching or damaging the cleaned metal layers. Therefore, since the present invention provides a cleaning process for a semiconductor device which is greatly simplified, the processing cost is reduced and the yield and reliability are improved.

**Claims**

1. A cleaning solution suitable for use in cleaning metal layers of a semiconductor device, wherein said solution consists of aqueous ammonia ($NH_4OH$), having a purity of 1-50%, methanol ($CH_3OH$)having a purity of 90-100%, hydrofluoric acid (HF) having a purity of 1-60% and deionized water ($H_2O$) having a pH of 9-11, in which the volume ratio of $NH_4OH$ to $CH_3OH$ to $H_2O$ is 1:10:1, and the volume of HF is 2000-10,000 ppm with regard to the mixture solution of $NH_4OH$, $CH_3OH$ and $H_2O$.

2. A method for cleaning metal layers on a semiconductor substrate, said method comprising the step of cleaning said semiconductor substrate having said metal layers formed thereon with the cleaning solution according to claim 1.

3. A cleaning method as claimed in claim 2, wherein the temperature of said cleaning solution is 20~100°C.

4. A cleaning method as claimed in claim 2 or claim 3, wherein the cleaning time during said cleaning step is 1-10 minutes.

5. A cleaning method as claimed in any of claims 2 to 4, wherein said metal layers are made of double layers of titanium and aluminum alloy.

6. A cleaning method as claimed in any of claims 2 to 4, wherein said metal layers are made of double layers of titanium nitride and aluminum alloy.

**Patentansprüche**

1. Reinigungslösung geeignet zur Verwendung beim Reinigen von Metallschichten einer Halbleitervorrichtung, worin die Lösung aus wässrigem Ammoniak ($NH_4OH$) mit einer Reinheit von 1-50 %, Methanol ($CH_3OH$) mit einer Reinheit von 90-100 %, Fluorwasserstoff (HF) mit einer Reinheit von 1-60 % und deionisiertem Wasser ($H_2O$) mit einem pH von 9-11 besteht, in der das Volumenverhältnis von $NH_4OH$ zu $CH_3OH$ zu $H_2O$ 1 : 10 : 1 beträgt, und das Volumen von HF 2000 bis 10000 ppm in Bezug auf die Mischungslösung aus $NH_4OH$, $CH_3OH$ und $H_2O$ beträgt.

2. Verfahren zum Reinigen von Metallschichten eines Halbleitersubstrats, wobei das Verfahren den Schritt zum Reinigen des Halbleitersubstrats mit darauf ausgebildeten Metallschichten mit der Reinigungslösung gemäß Anspruch 1 umfasst.

3. Reinigungsverfahren nach Anspruch 2, worin die Temperatur der Reinigungslösung 20-100 °C beträgt.

4. Reinigungsverfahren nach Anspruch 2 oder Anspruch 3, worin die Reinigungsdauer während des Reinigungsschrittes 1-10 Minuten beträgt.

5. Reinigungsverfahren nach einem der Ansprüche 2 bis 4, worin die Metallschichten aus Doppelschichten von Titan und Aluminiumlegierung gebildet sind.

6. Reinigungsverfahren nach einem der Ansprüche 2 bis 4, worin die Metallschichten aus Doppelschichten von Titannitrid und Aluminiumlegierung gebildet sind.

**Revendications**

1. Solution de nettoyage convenant à l'utilisation pour le nettoyage des couches métalliques d'un dispositif semi-conducteur, dans laquelle ladite solution comprend de l'ammoniac aqueux ($NH_4OH$) ayant une pureté de 1-50%, du méthanol ($CH_3OH$) ayant une pureté de 90-100%, de l'acide fluorhydrique (HF) ayant une pureté de 1-60% et de l'eau désionisée ($H_2O$) ayant un pH de 9-11, dans laquelle le rapport volumique de $NH_4OH$ à $CH_3OH$ à $H_2O$ est 1:10:1, et le volume de HF est 2000-10 000 ppm par rapport à la solution de mélange de $NH_4OH$, $CH_3OH$ et $H_2O$.

2. Procédé de nettoyage de couches métalliques sur un substrat de semi-conducteur, ledit procédé comprenant l'étape de nettoyage dudit substrat de semi-conducteur sur lequel sont formées lesdites couches métalliques avec la solution de nettoyage selon la revendication 1.

3. Procédé de nettoyage selon la revendication 2, dans lequel la température de ladite solution de nettoyage est 20-100°C.

4. Procédé de nettoyage selon la revendication 2 ou la revendication 3, dans lequel le temps de nettoyage pendant ladite étape de nettoyage est de 1-10 minutes.

5. Procédé de nettoyage selon l'une quelconque des revendications 2 à 4, dans lequel lesdites couches métalliques sont constituées de doubles couches d'alliage d'aluminium et de titane.

6. Procédé de nettoyage selon l'une quelconque des revendications 2 à 4, dans lequel lesdites couches métalliques sont constituées de doubles couches de nitrure de titane et d'alliage d'aluminium.

# FIG.1

# FIG.2

| CONDITION / SOLUTION | WAFER BEFORE CLEANING | WAFER AFTER CLEANING |
|---|---|---|
| NP-935 (PRIOR ART) | | |
| PRESENT INVENTION | | |
| SC-1 (PRIOR ART) | | |

## FIG.3(PRIOR ART)

## FIG.4

**FIG.5**

PH

13
11
9
7
4
2
0

0    1000  2000  3000  5000  10000

ADDED AMOUNT OF HF (PPM)

**FIG.6**

PH

12
10
8
6
4
2
0

0  INITIAL  2    4    6    8    (Hr)

PH OF CHEMICAL OVER TIME

**FIG.7**

$10^4$ca/cm

1000

DEPOSITED METAL LAYERS

100

FLOW METAL LAYERS

10

0

INITIAL    2    4    6    8    (Hr)

PIT CORROSION DENSITY
OF METAL LAYERS OVER TIME